# EUROPEAN PATENT SPECIFICATION

(11) **EP 4 325 590 B1**
(45) Date of publication and mention of the grant of the patent: **03.09.2025**
(21) Application number: 22791969.3
(22) Date of filing: 18.04.2022
(51) Int. Cl.: G06F 1/16, H10K 59/80

(54) **ELECTRONIC DEVICE COMPRISING DISPLAY HAVING DIFFUSE REFLECTION STRUCTURE**
ELEKTRONISCHE VORRICHTUNG MIT ANZEIGE MIT DIFFUSER REFLEXIONSSTRUKTUR
DISPOSITIF ÉLECTRONIQUE COMPRENANT UN DISPOSITIF D'AFFICHAGE AYANT UNE STRUCTURE DE RÉFLEXION DIFFUSE

(30) Priority: 19.04.2021 KR 20210050605
(43) Date of publication of application: 21.02.2024
(73) Proprietor: Samsung Electronics Co., Ltd., Suwon-si, Gyeonggi-do 16677 (KR)
(72) Inventor: UHM, Minsuk, Suwon-si, Gyeonggi-do 16677 (KR); SHIN, Sungyoung, Suwon-si, Gyeonggi-do 16677 (KR); JEON, Sangyong, Suwon-si, Gyeonggi-do 16677 (KR); SHIN, Hyunchang, Suwon-si, Gyeonggi-do 16677 (KR)
(74) Representative: HGF
(86) International application number: PCT/KR2022/005516
(87) International publication number: WO 2022/225269

(56) References cited:
- EP-A1- 3 996 359
- WO-A1-2020/243740
- WO-A1-2021/045594
- WO-A1-2021/051139
- CN-A- 109 643 380
- CN-A- 110 189 627
- KR-A- 20200 034 290
- KR-A- 20200 117 137
- KR-A- 20210 009 368

## Description

### [Technical Field]

Various embodiments disclosed in the document relate to an electronic device including a display having a diffuse reflection structure.

### [Background Art]

A display functions as a core interface which explicitly provides a process of an expression (e.g., output) and recognition (e.g., input) of information resource, and a recent electronic device equips a full screen display which provides a screen extending in order to promote enhanced interaction between the display and a user.

Implementation of the full screen display may require improvement of hardware or software of the electronic device. For example, an optical sensor (e.g., an image sensor, an illumination sensor, or a fingerprint sensor), which is conventionally disposed on the front surface of an electronic device or exposed through the front surface thereof, may be disposed under the display in order not to restrict screen extension of the display. In this case, a display area corresponding to the area in which the optical sensor is arranged may include a non-pixel area in which a part of pixel has been removed, so as to support the optical function of the optical sensor. WO 2020/243740 discloses an emissive display configured for through-display imaging.
WO 2021/045594 discloses an electronic device comprising a camera module.

### [Disclosure of Invention]

### [Technical Problem]

External light introduced into an electronic device through a non-pixel area of a display may be diffracted by metal wires existing around the non-pixel area, and the diffraction of the external light may degrade the performance of pixels disposed in a pixel area of the display. Accordingly, a display structure in which a shield member made of an opaque metal is disposed under the pixels to minimize an effect on the pixels by the diffraction of the external light is suggested.

However, in case that external light introduced through the non-pixel area is reflected by an optical sensor disposed under a display, the reflected light may be reflected again by a shield member and then enter the optical sensor. The reflected light entering the optical sensor in this way may also degrade the performance of the optical sensor.

Various embodiments disclosed in the document may provide an electronic device including a display having a diffuse reflection structure, wherein the diffuse reflection structure is implemented in a shield member included in the display, so as to minimize the amount of reflected light incident to an optical sensor from the shield member.

### [Solution to Problem]

An electronic device according to a first aspect is set out in accordance with claim 1.

An electronic device according to the invention includes an optical sensor disposed under the display panel.

The display panel includes a first area having a first pixel density and corresponding to an angle of view of the optical sensor, a second area having a second pixel density greater than the first pixel density, and an opaque layer disposed to correspond to the first area in the display panel.

The opaque layer includes a plurality of opaque third areas each comprising a metal layer having a designated pattern structure and a plurality of fourth areas including an opening between the plurality of third areas, wherein each opening supports an optical path for external light introduced through the first area to the optical sensor; and wherein the designated pattern structure is formed at a side of the metal layer toward the optical sensor, and wherein the designated pattern structure comprises a structural shape to enable diffuse reflection of reflected light from the optical sensor.

### [Advantageous Effects of Invention]

According to various embodiments, a display mechanism capable of minimizing the amount of reflected light incident to an optical sensor from a shield member by implementing a diffuse reflection structure in the shield member included in a display may be provided.

According to various embodiments, the amount of reflected light incident to the optical sensor may be minimized to suppress the performance deterioration of the optical sensor.

In addition, various effects directly or indirectly understood through this document may be provided.

### [Brief Description of Drawings]

FIG. 1 is a view illustrating an electronic device within a network environment according to an embodiment.
FIG. 2 is a view illustrating a display device according to an embodiment.
FIG. 3 is a view illustrating a first area and a second area of a display device according to an embodiment.
FIG. 4 is a cross-sectional view of one area of an electronic device according to an embodiment.
FIG. 5 is an enlarged view of one area of an electronic device according to an embodiment.
FIG. 6 is an enlarged view of another area of an electronic device according to an embodiment.
FIG. 7 is an enlarged view of an opaque layer included in a display of an electronic device according to an embodiment.
FIG. 8 is a view illustrating a manufacturing process of an opaque layer included in a display of an electronic device according to an embodiment.
FIG. 9 is a view illustrating various pattern structures of an opaque layer included in a display of an electronic device according to an embodiment.
FIG. 10 is a view illustrating one example of an improvement with respect to another area of an electronic device according to an embodiment.
FIG. 11 is a view illustrating another example of an improvement with respect to another area of an electronic device according to an embodiment.

In connection with description of drawings, identical or corresponding components may be given identical reference numerals.

### [Mode for Carrying out the Invention]

In the following description of various embodiments, although numerous features may be designated as optional, it is nevertheless acknowledged that all features defined by appended claim 1 are not to be read as optional.

Hereinafter, various embodiments of the present disclosure are disclosed with reference to the accompanying drawings.

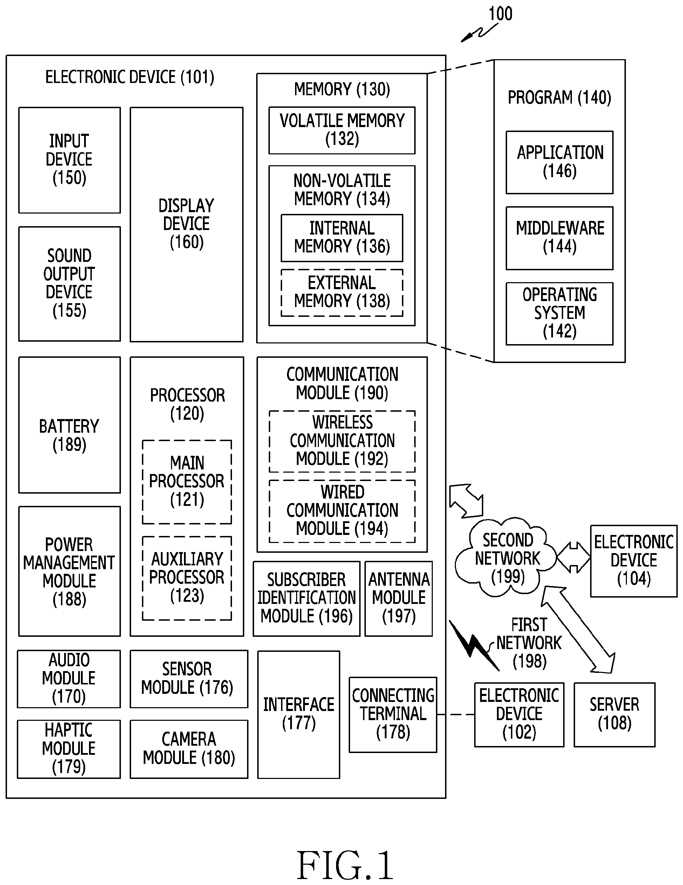

FIG. 1 is a view illustrating an electronic device within a network environment according to an embodiment.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

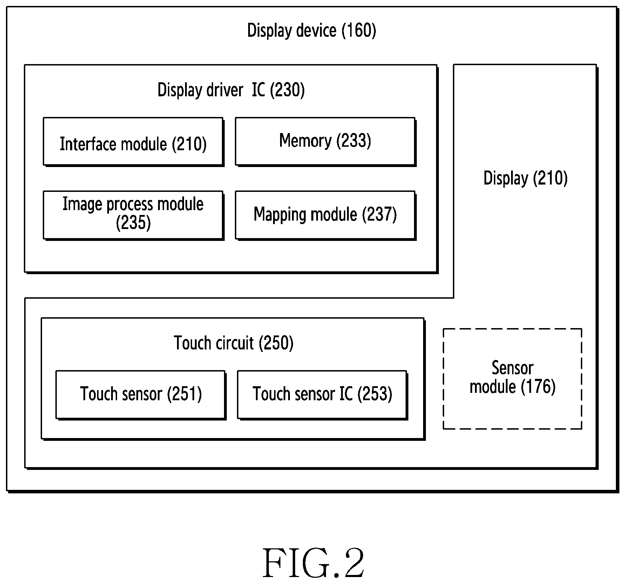

FIG. 2 is a view illustrating a display device according to an embodiment.

Referring to FIG. 2, the display device 160 may include a display 210 and a display driver integrated circuit (DDI) 230 to control the display 210. The DDI 230 may include an interface module 231, memory 233 (e.g., buffer memory), an image processing module 235, or a mapping module 237. The DDI 230 may receive image information that contains image data or an image control signal corresponding to a command to control the image data from another component of the electronic device 101 via the interface module 231. For example, according to an embodiment, the image information may be received from the processor 120 (e.g., the main processor 121 (e.g., an application processor)) or the auxiliary processor 123 (e.g., a graphics processing unit) operated independently from the function of the main processor 121. The DDI 230 may communicate, for example, with touch circuitry 150 or the sensor module 176 via the interface module 231. The DDI 230 may also store at least part of the received image information in the memory 233, for example, on a frame by frame basis. The image processing module 235 may perform pre-processing or post-processing (e.g., adjustment of resolution, brightness, or size) with respect to at least part of the image data. According to an embodiment, the pre-processing or post-processing may be performed, for example, based at least in part on one or more characteristics of the image data or one or more characteristics of the display 210. The mapping module 237 may generate a voltage value or a current value corresponding to the image data pre-processed or post-processed by the image processing module 235. According to an embodiment, the generating of the voltage value or current value may be performed, for example, based at least in part on one or more attributes of the pixels (e.g., an array, such as an RGB stripe or a pentile structure, of the pixels, or the size of each subpixel). At least some pixels of the display 210 may be driven, for example, based at least in part on the voltage value or the current value such that visual information (e.g., a text, an image, or an icon) corresponding to the image data may be displayed via the display 210.

According to an embodiment, the display device 160 may further include the touch circuitry 250. The touch circuitry 250 may include a touch sensor 251 and a touch sensor IC 253 to control the touch sensor 251. The touch sensor IC 253 may control the touch sensor 251 to sense a touch input or a hovering input with respect to a certain position on the display 210. To achieve this, for example, the touch sensor 251 may detect (e.g., measure) a change in a signal (e.g., a voltage, a quantity of light, a resistance, or a quantity of one or more electric charges) corresponding to the certain position on the display 210. The touch circuitry 250 may provide input information (e.g., a position, an area, a pressure, or a time) indicative of the touch input or the hovering input detected via the touch sensor 251 to the processor 120. According to an embodiment, at least part (e.g., the touch sensor IC 253) of the touch circuitry 250 may be formed as part of the display 210 or the DDI 230, or as part of another component (e.g., the auxiliary processor 123) disposed outside the display device 160.

According to an embodiment, the display device 160 may further include at least one sensor (e.g., a fingerprint sensor, an iris sensor, a pressure sensor, or an illuminance sensor) of the sensor module 176 or a control circuit for the at least one sensor. In such a case, the at least one sensor or the control circuit for the at least one sensor may be embedded in one portion of a component (e.g., the display 210, the DDI 230, or the touch circuitry 150)) of the display device 160. For example, when the sensor module 176 embedded in the display device 160 includes a biometric sensor (e.g., a fingerprint sensor), the biometric sensor may obtain biometric information (e.g., a fingerprint image) corresponding to a touch input received via a portion of the display 210. As another example, when the sensor module 176 embedded in the display device 160 includes a pressure sensor, the pressure sensor may obtain pressure information corresponding to a touch input received via a partial or whole area of the display 210. According to an embodiment, the touch sensor 251 or the sensor module 176 may be disposed between pixels in a pixel layer of the display 210, or over or under the pixel layer.

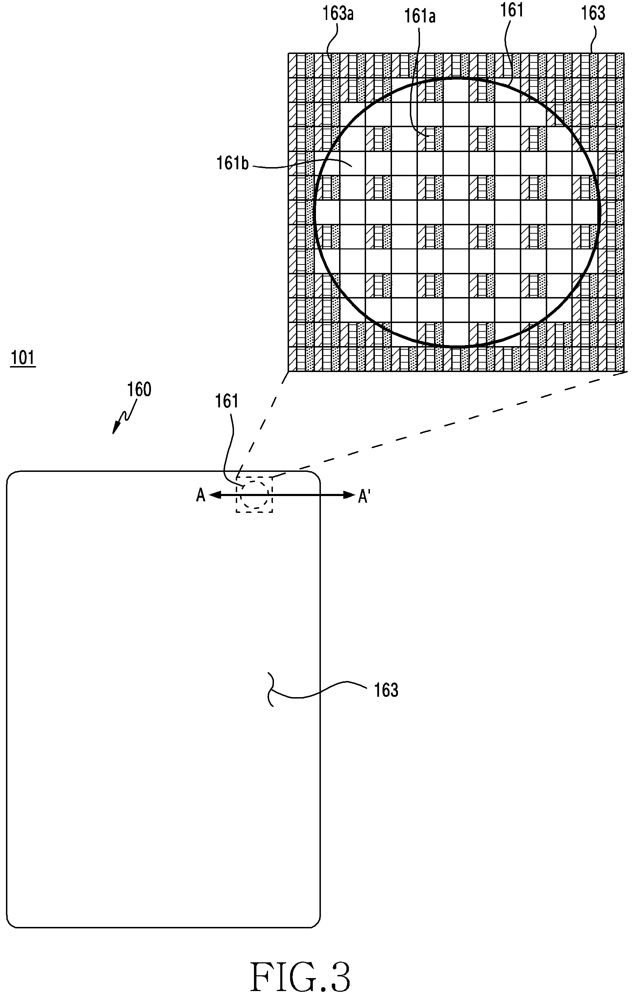

FIG. 3 is a view illustrating a first area and a second area of a display device according to an embodiment.

Referring to FIG. 3, a display device 160 (e.g., a display of the display device 160, hereinafter, refers to the display 210 of FIG. 2) of an electronic device 101 according to an embodiment may include at least one of a first area 161 and a second area 163.

In one embodiment, at least one first area 161 may be configured in various areas of the display 210 according to an embodiment. For example, at least one first area 161 may be configured on at least one of the upper right area, the upper central area, and the upper left area adjacent to the upper edge of the display 210. For another example, at least one first area 161 may be configured in an area in which the body (e.g., finger) of a user may easily approach when the electronic device 101 is gripped by the user. For example, the at least one first area 161 may be configured on the lower central area adjacent to the lower edge of the display 210. In an embodiment, the second area 163 may be configured to occupy all areas of the display 210 excluding the at least one first area 161.

In an embodiment, at least one optical sensor may be disposed under each of at least one first area 161 of the display 210. For example, the at least one optical sensor may be disposed to be perpendicularly aligned with at least one first area 161 under the display 210. For another example, at least a part of the at least one optical sensor may be disposed to perpendicularly overlap the at least one first area 161 under the display 210.

According to an embodiment, at least one optical sensor may include at least one of an image sensor configured to support image photographing with respect to a surrounding area (e.g., a front side of the electronic device 101, which the display 210 faces) of the electronic device 101, an illustration sensor configured to detect a surrounding state (e.g., the amount of light) of the electronic device 101, and a biometric sensor (e.g., a fingerprint sensor or an iris sensor) configured to support bio-information acquisition of a user of the electronic device 101. According to various embodiments, in accordance with the size, the area, the shape, or the angle of view of at least one optical sensor, the size, the area, or the shape of at least one first area 161 may be determined to correspond thereto.

In an embodiment, each of the at least one first area 161 and the second area 163 may include a plurality of pixels, and each of the plurality of pixels may include at least one sub pixel. For example, at least one pixel among the plurality of pixels may include an RGB stripe structure configured by a combination of a red sub pixel, a green sub pixel, and a blue sub pixel disposed on the same line. For another example, at least one pixel among the plurality of pixels may include an RGBW stripe structure configured by a combination of a red sub pixel, a green sub pixel, a blue sub pixel, and a white sub pixel disposed on the same line. For another example, at least one pixel among the plurality of pixels may include an RGBG diamond PenTile structure configured by a combination of a red sub pixel having a first size, a blue sub pixel having a second size larger than the first size, and a plurality of green sub pixels having a third size smaller than the first size.

According to various embodiments, the type, the structure, or the arrangement of at least one sub pixel included in each of a plurality of pixels may be equal to or different from each other. For example, as an example of a case in which the RGB stripe structure is implemented in at least one first area 161, a first pixel among the plurality of pixels included in the at least one first area 161 may include a red sub pixel, a second pixel adjacent to the right side with reference to the first pixel may include a green sub pixel, and a third pixel adjacent to the right side with reference to the second pixel may include a blue sub pixel. For another example, as an example of a case in which the RGBG diamond PenTile structure is implemented in at least one first area 161, a first pixel among the plurality of pixels included in the at least one first area 161 may include a red sub pixel and a green sub pixel, and a second pixel adjacent to the right side with reference to the first pixel may include a blue sub pixel and a green sub pixel. For another example, the sub pixels of an RGB stripe structure may be arranged in each of the plurality of pixels included in at least one first area 161, and the sub pixels of an RGBG diamond PenTile structure may be arranged in each of the plurality of pixels included in the second area 163.

According to an embodiment, at least one first area 161 may include a pixel structure different from that of the second area 163 so as to support an optical function of at least one optical sensor disposed to correspond to the at least one first area 161, along with displaying of a content corresponding to image information. For example, at least one first area 161 may include a plurality of first pixel areas 161a in which a pixel is disposed and a plurality of non-pixel areas 161b in which a pixel is not disposed, and the second area 163 may include a plurality of second pixel areas 163a in which a pixel is disposed. Based on this, at least one first area 161 and the second area 163 may support content displaying with respect to all areas of the display 210 based on each of the plurality of first pixel areas 161a and the plurality of second pixel areas 163a. In addition, at least one first area 161 may implement light-transmission with respect to the display 210 based on the plurality of non-pixel areas 161b so as to support receiving light from the outside into at least one optical sensor or transmitting light from the at least one optical sensor to the outside.

In various embodiments, the plurality of first pixel areas 161a and the plurality of non-pixel areas 161b included in at least one first area 161 may be disposed in a regular array or in an irregular array. In various embodiments, the plurality of first pixel areas 161a may have the same area or different areas from each other and, similarly, the plurality of non-pixel areas 161b may have the same area or different areas from each other. In various embodiments, all of the plurality of first pixel areas 161a and the plurality of non-pixel areas 161b may have the same area. In various embodiments, the total area of the plurality of first pixel areas 161a may be equal to or different from the total area of the plurality of non-pixel areas 161b. According to various embodiments, at least one electrical wire or circuit (e.g., thin film transistor, TFT) relating to driving of a pixel may be arranged in the same array or different arrays in each of the plurality of first pixel areas 161a.

According to an embodiment, the pixel density between the at least one first area 161 and the second area 163 may be different due to the plurality of non-pixel areas 161b included in the at least one first area 161. The at least one first area 161 includes a plurality of first pixel areas 161a in which a pixel is disposed based on a first pixel density, and the second area 163 includes a plurality of second pixel areas 163a in which a pixel is disposed based on a second pixel density greater than the first pixel density. For example, when at least one first area 161 has a first pixel density of 75%, 50%, or 25% while having a non-pixel density of 25%, 50%, or 75%, the second area 163 may have a second pixel density of 100%. According to an embodiment, in accordance with the first pixel density and the second pixel density which are different from each other, the number of pixels per a unit area included in at least one first area 161 may be smaller than the number of pixels per a unit area included in the second area 163.

In various embodiments, the size or area of at least one sub pixel included in each of the plurality of first pixel areas 161a may be equal to or different from the size or area of at least one sub pixel included in each of the plurality of second pixel areas 163a. In this regard, at least one first area 161 may have a brightness (or luminance) lower than that of the second area 163 due to the first pixel density (or due to the plurality of non-pixel areas 161b). Further, in case that a large driving power is supplied to the at least one first area 161 in order to perform a control for uniform brightness between the at least one first area 161 and the second area 163, at least a part of pixels of the plurality of first pixel areas 161a may be deteriorated (e.g., burned-in). In order to prevent the pixel deterioration, the size or area of at least one sub pixel included in each of the plurality of first pixel areas 161a may be configured to be larger than the size or area of at least one sub pixel included in each of the plurality of second pixel areas 163a. Otherwise, regardless of prevention of the pixel deterioration, in order to increase the light transmittance with respect to at least one first area 161, the size or area of at least one sub pixel included in each of the plurality of first pixel areas 161a may be configured to be smaller than the size or area of the at least one sub pixel included in each of the plurality of second pixel areas 163a.

In various embodiments, the shape of at least one sub pixel included in each of the plurality of first pixel areas 161a may be equal to or different from the shape of at least one sub pixel included in each of the plurality of second pixel areas 163a. For example, in order to increase light transmittance with respect to at least one first area 161 or to minimize an optical effect on a lower optical sensor by the plurality of sub pixels arranged in the at least one first area 161, the shape of at least one sub pixel included in each of the plurality of first pixel areas 161a may be different from the shape of at least one sub pixel included in each of the plurality of second pixel areas 163a. As an example of a case in which an RGBG diamond PenTile structure is implemented in at least one first area 161, a red sub pixel and a blue sub pixel included in the plurality of first pixel areas 161a may have a rhombic shape corners (or edges) which are processed to be rounded, and a green sub pixel may have a substantially oval shape.

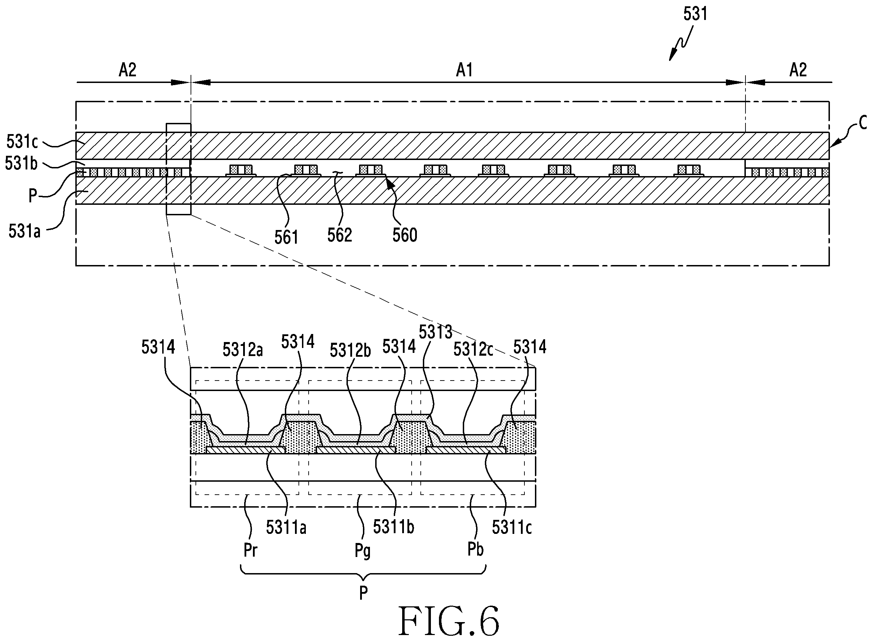

According to an embodiment, the display layer structures (or, structures in each of which layers included in a display are stacked) with respect to the at least one first area 161 and the second area 163 may be different from each other. An opaque layer (e.g., an opaque layer 560 of FIG. 6 as described below) is disposed in a display panel corresponding to at least one first area 161, and an opaque layer may be omitted in the display panel corresponding to the second area 163. According to another embodiment, the at least one first area 161 and the second area 163 may have the same display layer structure. For example, the opaque layer may be identically disposed in the display panel corresponding to the at least one first area 161 and the second area 163.

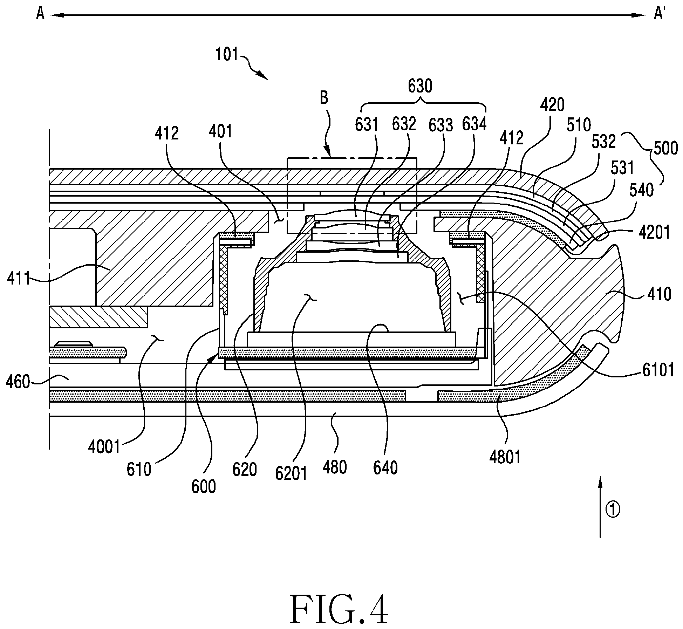

FIG. 4 is a cross-sectional view of one area of an electronic device according to an embodiment. For one area of the electronic device, the A-A' area illustrated in FIG. 3 may be referred to.

The embodiment of FIG. 4 is explained below by referring to an unbreakable (UB) type OLED display (e.g., curved display), as an example. However, the embodiment below may be applied equally or similarly to an OCTA (on cell touch AOLED (active matrix organic light-emitting diode)) type flat display. Further, in explaining the embodiment of FIG. 4, an image sensor of a camera device disposed under a display is referred to as an example of the optical sensor described above. However, the following embodiment may be identically applied to various optical sensors such as an illumination sensor or a biometric sensor disposed under the display.

Referring to FIG. 4, the electronic device 101 according to an embodiment may include a front surface cover 420 (e.g., a front surface cover member, a front surface plate, a front surface window, or a first plate) facing a first direction (e.g., ① direction), a rear surface cover 480 (e.g., a rear surface cover member, a rear surface plate, a rear surface window, or a second plate) facing a direction opposite to the first direction, and a lateral surface member 410 surrounding a space 4001 between the front surface cover 420 and the rear surface cover 480.

In an embodiment, the electronic device 101 may include a first waterproof member 4201 disposed between the lateral surface member 410 and a subsidiary material layer 540 of a display 500 and a second waterproof member 4801 disposed between the lateral surface member 410 and the rear surface cover 480. The first waterproof member 4201 and the second waterproof member 4801 may prevent foreign matter or moisture from the outside from being introduced into the inner space 4001 of the electronic device 101. In various embodiments, at least one of the first waterproof member 4201 and the second waterproof member 4801 may be substituted with an adhesive member. In various embodiments, the electronic device 101 may further include a third waterproof member disposed in at least a part between a camera device 600 and the lateral surface member 410.

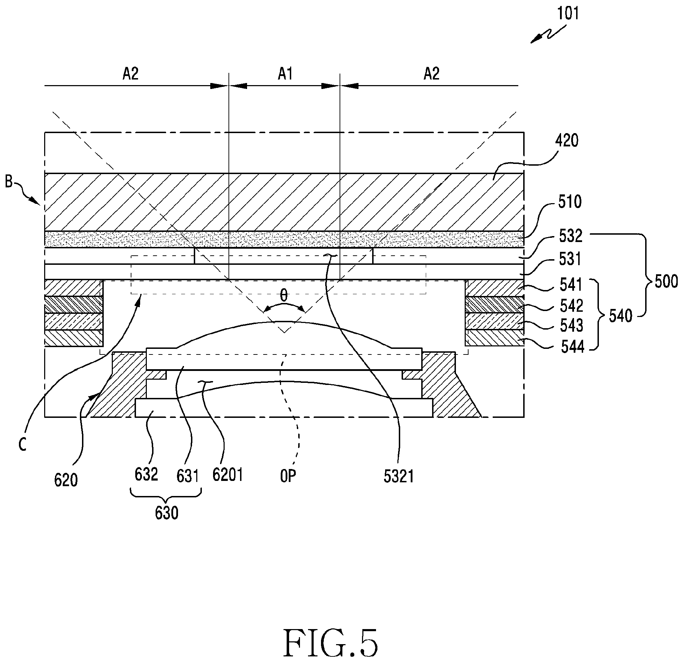

According to an embodiment, the lateral surface member 410 may include a first support member 411 at least partially extending toward the inner space 4001 of the electronic device 101. The first support member 411 may be configured by structural combination with the lateral surface member 410, for example. In an embodiment, the first support member 411 may support at least a part of the camera device 600 so that the camera device 600 is to be aligned near the rear surface of a display panel 531 through an opening (e.g., opening (OP) of FIG. 5) configured through the subsidiary material layer 540 of the display 500.

In an embodiment, the camera device 600 may include a camera housing 610, a lens housing 620 disposed in an inner space 6101 of the camera housing 610 to at least partially protrude toward the display 500, a plurality of lenses 630 (631, 632, 633, and 634) arranged in an inner space 6201 of the lens housing 620 at a predetermined interval, and at least one image sensor 640 disposed to acquire at least a part of light passing through the plurality of lenses 630 in the inner space 6101 of the camera housing 610. In an embodiment, the camera device 600 may be disposed to be aligned with a through-hole 401 of the first support member 411, and then attached to one area of the first support member 411 through an adhesive member 412 (e.g., a bonding member and a tape member). In another example, the camera device 600 may not include the camera housing 610 in order to reduce a space occupied by the camera device 600 and in this case, the lens housing 620 may be directly attached to one area of the first support member 411 through a predetermined array process. In another embodiment, the camera device 600 may be disposed to be supported by a second support member 460 (e.g., rear case) disposed in the inner space 4001 of the electronic device 101.

In an embodiment, in a case that the camera device 600 includes an auto focus (AF) function, the lens housing 620 may be moved by a predetermined driving unit disposed in the inner space 6101 of the camera housing 610. In result, the distance between the lens housing 620 and the display panel 531 may vary. In various embodiments, with regard to an AF function performance of the camera device 600, the driving unit may change a position of at least one lens of the plurality of lenses 630.

FIG. 5 is an enlarged view of one area of an electronic device according to an embodiment. For the one area of the electronic device, area B illustrated in FIG. 4 may be referred to.

Referring to FIG. 4 and FIG. 5, the display 500 according to an embodiment may include at least one of a touch panel, a polarization layer 532, the display panel 531, and the subsidiary material layer 540 (e.g., the subsidiary material layer 540 including at least one of a shielding layer 541, a buffering layer 542, a digitizer, a functional member 543, and a conductive member 544). In an embodiment, the display 500 may be coupled to the front surface cover 420 based on an adhesive layer 510 disposed on the rear surface of the front surface cover 420.

In an embodiment, the polarization layer 532 may include an opening 5321 for supporting an optical function of the camera device 600 in one area at least partially overlapping the camera device 600. Similarly, in order to support an optical function of the camera device 600, one area of the adhesive layer 510 disposed on the polarization layer 532 may be at least partially omitted, the one area corresponding to the opening 5321 of the polarization layer 532. In an embodiment, a material (e.g., an index matching material) for controlling refractive index of light according to interfacial reflection increase may be filled in the opening 5321 configured in the polarization layer 532. In another embodiment, one area of the polarization layer 532 which at least partially overlaps the camera device 600 may not include the opening 5321, and may be configured to have high light transmittance. For example, one area of the polarization layer 532 corresponding to the plurality of lenses 630 of the camera device 600 may be made of a material having light transmittance different from that of another area of the polarization layer 532, or may be configured to include a member to increase light transmittance. In another example, one area of the polarization layer 532 which at least partially overlaps the camera device 600 may not include the opening 5321, or may be made of a material having light transmittance equal to that of another area of the polarization layer 532. According to another embodiment, the polarization layer 532 may be omitted from the display 500, and the omitted polarization layer 532 may be replaced with a color filter layer configured by a combination of a black matrix and a color filter disposed on the black matrix. Otherwise, the omitted polarization layer 532 may be replaced with a combination of a color filter layer and a planarization layer (e.g., over coat) disposed on the color filter layer.

According to an embodiment, the subsidiary material layer 540 of the display 500 may include an opening (OP) configured in an area which at least partially overlaps the plurality of lenses 630 of the camera device 600. In an embodiment, the opening (OP) may be configured according to a method in which an opening configured in the shielding layer 541, an opening configured in the buffering layer 542, an opening configured in the functional member 543, and an opening configured in the conductive member 544 overlap one another. According to various embodiments, the sizes of the opening configured in the shielding layer 541, the opening configured in the buffering layer 542, the opening configured in the functional member 543, and the opening configured in the conductive member 544 may be different from each other according to the shape of the camera device 600 (or, the shapes of the plurality of lenses 630).

In an embodiment, the display panel 531 may include active areas A1 and A2, and the active areas A1 and A2 may include a transmitting area A1 which is an area corresponding to an angle of view θ of the camera device 600 disposed under the display panel 531. According to an embodiment, the transmitting area A1 (e.g., at least one first area 161 of FIG. 3) may be configured to have light transmittance which is higher than that of the surrounding active area A2 (e.g., the second area 163 of FIG. 3). For example, the transmitting area A1 may be configured to have light transmittance within a designated range through rearrangement with respect to at least one of a plurality of wires and a plurality of pixels included in the display panel 531. According to various embodiments, the display panel 531 corresponding to the transmitting area A1 may include an opaque layer (e.g., the opaque layer 560 of FIG. 6). The opaque layer may include a plurality of openings (e.g., a plurality of openings 562 of FIG. 6), and the light transmittance of the transmitting area A1 may be determined through control with respect to at least one of the shape, the size, the arrangement, the density, and the interval of the plurality of openings.

FIG. 6 is an enlarged view of another area of an electronic device according to an embodiment. For another area of the electronic device, area C illustrated in FIG. 5 may be referred to.

Referring to FIG. 6, the display panel 531 according to an embodiment may include a substrate layer 531a, an intermediate layer 531b stacked on the substrate layer 531a, and a protection layer 531c (encap-layer) stacked on the intermediate layer 531b. In an embodiment, the display panel 531 may include a plurality of pixels (Ps) arranged to correspond to the active areas A1 and A2, and each of the plurality of pixels (Ps) may include a first sub pixel area (pixel red, Pr), a second sub pixel area (pixel green, Pg), and a third sub pixel area (pixel blue, Pb).

According to an embodiment, the display panel 531 may include a first pixel electrode 5311a, a second pixel electrode 5311b, and a third pixel electrode 5311c disposed on the substrate layer 531a to correspond to the first sub pixel area (Pr), the second sub pixel area (Pg), and the third sub pixel area (Pb), respectively, in the intermediate layer 531b. The first pixel electrode 5311a, the second pixel electrode 5311b, and the third pixel electrode 5311c may include, for example, a reflecting electrode including a reflection layer. According to an embodiment, the display panel 531 may include a first organic material layer 5312a, a second organic material layer 5312b, and a third organic material layer 5312c disposed on the first pixel electrode 5311a, the second pixel electrode 5311b, and the third pixel electrode 5311c, respectively, in the intermediate layer 531b. In an embodiment, the first sub pixel area (Pr), the second sub pixel area (Pg), and the third sub pixel area (Pb) may be partitioned by a pixel definition layer 5314 made of an insulation material, and an opposite electrode 5313 may be commonly disposed on the first organic material layer 5312a, the second organic material layer 5312b, and the third organic material layer 5312c.

According to an embodiment, each of the first organic material layer 5312a, the second organic material layer 5312b, and the third organic material layer 5312c may include an organic light emitting layer which emits light of a first color (e.g., red), a second color (e.g., green), and a third color (e.g., blue). In an embodiment, the organic light emitting layer may be disposed between one pair of common layers which are vertically stacked thereon. One common layer among the one pair of common layers may include at least one of a hole injection layer (HIL) and a hole transport layer (HTL), and the other common layer may include at least one of an electron transport layer (ETL) and an electron injection layer (EIL). According to various embodiments, the one pair of common layers may further include various functional layers while including the organic light emitting layer.

In various embodiments, the opposite electrode 5313 may be configured as a transparent or a translucence electrode in a thin film shape having a thickness of several mm to several tens of mm, and may include one or more materials selected from silver (Ag), aluminum (Al), magnesium (Mg), lithium (Li), calcium (Ca), cooper (Cu), LiF/Ca, LiF/Al, MgAg, and CaAg. According to an embodiment, light emitted from the first organic light emitting layer, the second organic light emitting layer, and the third organic light emitting layer included in the first organic material layer 5312a, the second organic material layer 5312b, and the third organic material layer 5312c, respectively, may be emitted directly or emitted after being reflected by the first pixel electrode 5311a, the second pixel electrode 5311b, and the third pixel electrode 5311c, respectively, toward the opposite electrode 5313.

According to an embodiment, the substrate layer 531a may include a connection member electrically connected to each of the first pixel electrode 5311a, the second pixel electrode 5311b, and the third pixel electrode 5311c. The connection member may include, for example, a thin film transistor (TFT) or a low temperature passivation transistor (LTPS). In an embodiment, the substrate layer 531a may include a transparent insulation substrate (e.g., glass substrate, quartz substrate or resin substrate). According to an embodiment, the protection layer 531c may be disposed on the opposite electrode 5313 in order to protect the opposite electrode 5313.

The display panel 531 includes a plurality of pixels (Ps) arranged to have a density smaller than that of the surrounding active area A2 (e.g., the second area 163 of FIG. 3) in the intermediate layer 531b corresponding to the transmitting area A1 (e.g., at least one first area 161 of FIG. 3). In this case, the intermediate layer 531b corresponding to the transmitting area A1 may remain or may be omitted.

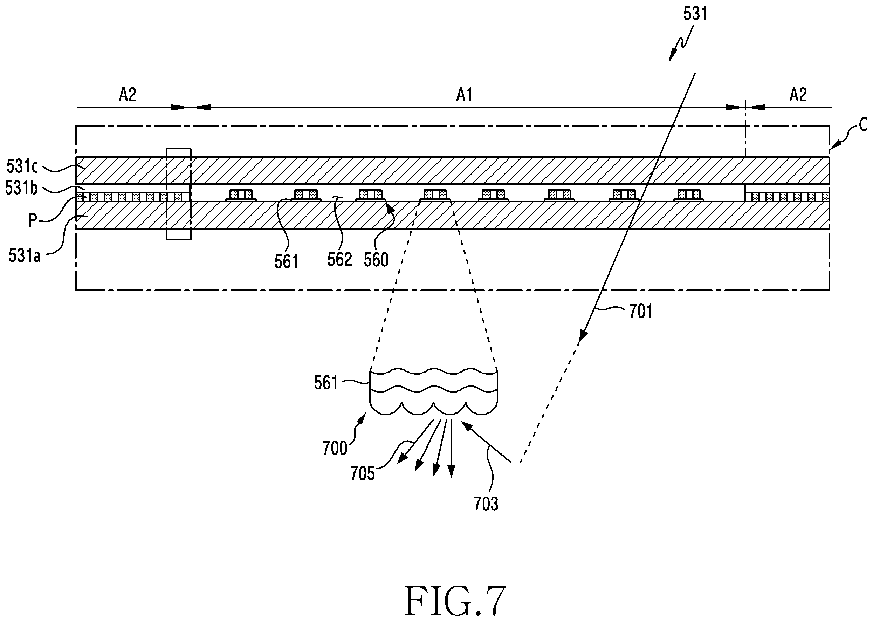

FIG. 7 is an enlarged view illustrating an opaque layer included in a display of an electronic device according to an embodiment.

Referring to FIG. 6 and FIG. 7, the display panel 531 according to an embodiment may include an opaque layer 560 disposed in the intermediate layer 531b of the display panel 531 in order to correspond to the transmitting area A1 (e.g., at least one first area 161 of FIG. 3). In an embodiment, the opaque layer 560 may be disposed between a plurality of pixels (Ps) arranged in the intermediate layer 531b corresponding to the transmitting area A1 and the substrate layer 531a of the display panel 531. In an embodiment, the opaque layer 560 may be disposed at the boundary between the transmitting area A1 and the surrounding active area A2 (e.g., the second area 163 of FIG. 3).

According to various embodiments, the opaque layer 560 may be disposed under the display panel 531. For example, the opaque layer 560 may be disposed on the rear surface of the substrate layer 531a of the display panel 531.

In an embodiment, the opaque layer 560 may include a plurality of areas, each of which includes a colored (e.g., black) metal layer 561 (e.g., shield member), and a plurality of areas, each of which includes the opening 562 between the metal layers 561. The metal layers 561 included in the opaque layer 560 may be used to minimize diffraction of external light introduced through the transmitting area A1 of the display panel 531. In addition, the openings 562 included in the opaque layer 560 may be used to support an optical path of light emitted from the camera device 600 or light introduced into the camera device (e.g., the camera device 600 of FIG. 4) disposed under the display panel 531. Light transmittance of the transmitting area A1 may be determined by controlling at least one of the shape, the size, the arrangement density, and the arrangement interval of the openings 562, and at least one of the shape, the size, the arrangement density, and the arrangement interval of the openings 562 may be equal to or different from each other.

According to an embodiment, at least one of a plurality of wires and a plurality of pixels (Ps) arranged to correspond to the transmitting area A1 of the display panel 531 may be aligned to be perpendicular to the metal layers 561 of the opaque layer 560 and may be disposed so as not to overlap the openings 562 of the opaque layer 560. According to another embodiment, at least one of a plurality of wires and a plurality of pixels (Ps) arranged to correspond to the transmitting area A1 of the display panel 531 may be disposed to at least partially overlap the openings 562 of the opaque layer 560.

According to an embodiment, a plurality of areas corresponding to the metal layers 561 of the opaque layer 560 may include a designated pattern structure 700. In an embodiment, the pattern structure 700 may be directly implemented in each of the metal layers 561, or may be implemented by depositing a member including the pattern structure 700 in each of the metal layers 561. According to various embodiments, the pattern structure 700 may include at least one regular or irregular pattern from among an embossing pattern, an uneven pattern, a protrusion pattern, a hairline pattern and a pattern obtained by combining at least two of the above-mentioned patterns. In various embodiments, at least one of the embossing pattern, the uneven pattern, the protrusion pattern, the hairline pattern may be configured to have at least one of a height of a first size (e.g., 1 *µ*m) and a width of a second size (e.g., 5 *µ*m). In various embodiments, at least one of the embossing pattern, the uneven pattern, the protrusion pattern, the hairline pattern may be spaced apart by a predetermined width from an adjacent embossing pattern, uneven pattern, protrusion pattern, hairline pattern or may be continuously configured without being spaced apart therefrom.

The pattern structure 700 included in the metal layers 561 of the opaque layer 560 is used for diffuse reflection of light toward the metal layers 561. In this regard, at least a part of external light 701 introduced through the transmitting area A1 is reflected by a component (e.g., at least one of the plurality of lenses 630 of FIG. 4) of the camera device 600 disposed under the display panel 531, and at least a part of reflected light 703 is oriented toward the metal layers 561. In case that the metal layers 561 are implemented to have a flat shape, the reflected light 703 oriented toward the metal layer 561 may be secondarily reflected by the metal layer 561 and at least a part thereof may be introduced into the camera device 600. In this case, performance deterioration of another component (e.g., the image sensor 640 of FIG. 4) of the camera device 600 may be caused by the light introduced into the camera device 600. Based on this, the pattern structure 700 of the metal layers 561 diffuses reflection 705 of the reflected light 703 progressing toward the metal layer 561, in unspecified multiple directions, based on a structural shape having a curve, to reduce the amount of the reflected light introduced into the camera device 600.

According to various embodiments, the opaque layer 560 may be disposed in the intermediate layer 531b of the display panel 531 to correspond to all of the transmitting area A1 and the surrounding active area A2. For example, the opaque layer 560 may be disposed between the substrate layer 531a and a plurality of pixels (Ps) arranged in the intermediate layer 531b to correspond to the transmitting area A1 and between the substrate layer 531a and a plurality of pixels (Ps) arranged in the intermediate layer 531b to correspond to the surrounding active area A2. In this case, the metal layer 561 of the opaque layer 560 corresponding to the transmitting area A1 and the metal layer 561 of the opaque layer 560 corresponding to the surrounding active area A2 may have different sizes. For example, the metal layer 561 of the opaque layer 560 corresponding to the transmitting area A1 may be configured to have a first size capable of covering a plurality of wires and a plurality of pixels (Ps) arranged to correspond to the transmitting area A1 in order to minimize diffraction of external light, and the metal layer 561 of the opaque layer 560 corresponding to the surrounding active area A2 may be configured to have a second size smaller than the first size in order to prevent an IR drop of an LTPS or a thin film transistor included in the substrate layer 531a. In addition, the metal layer 561 of the opaque layer 560 corresponding to the transmitting area A1 and the metal layer 561 of the opaque layer 560 corresponding to the surrounding active area A2 may have different shapes. For example, the metal layer 561 of the opaque layer 560 corresponding to the transmitting area A1 may be configured to have a shape having the pattern structure 700 such as the embossing pattern, the uneven pattern, the protrusion pattern, and the hairline pattern, and a pattern obtained by combining at least two thereof, and the metal layer 561 of the opaque layer 560 corresponding to the surrounding active area A2 may be configured to have a flat shape.

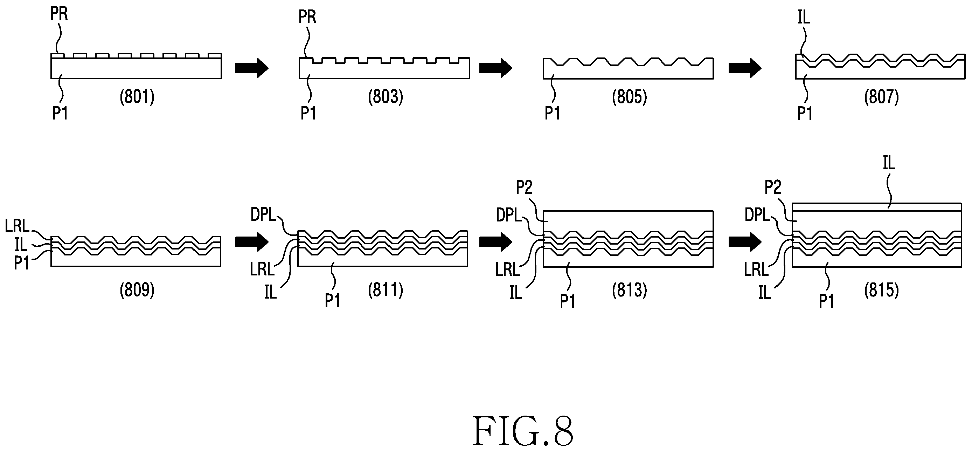

FIG. 8 is a view illustrating a manufacturing process of an opaque layer (e.g., a metal layer of an opaque layer) included in a display of an electronic device according to an embodiment.

Referring to FIG. 7 and FIG. 8, the metal layers 561 of the opaque layer 560 according to an embodiment may be configured through a series of the photolithography processes so as to include the pattern structure 700. For example, in a first process 801 and a second process 803, photoresist (PR) may be coated on one side surface of a first polymer (polymer1, P1) in a regular or an irregular array, and may partially remove one side surface of the first polymer (P1) through etching. In a third process 805 and a fourth process 807, in order to enable the etched side surface of the first polymer (P1) to have at least one shape of the embossing, the uneven surface, the protrusion, and the hairline corresponding to the pattern structure 700, the one side surface of the first polymer (P1) may be processed along with removal of the photoresist (PR), and an inorganic layer (IL) corresponding to the shape of the pattern structure 700 may be disposed on the processed side surface of the first polymer (P1). In a fifth process 809 and a sixth process 811, a low reflective layer (LRL) and a diffraction prevention layer (DPL) (e.g., the metal layer 561 included in the opaque layer 560 of FIG. 7) corresponding to the shape of the pattern structure 700 may be sequentially disposed on the inorganic layer (IL). In a seventh process 813 and an eighth process 815, a second polymer (polymer2, P2) and the inorganic layer (IL) may be sequentially disposed on the diffraction prevention layer (DPL).

In the embodiment of FIG. 8, a process example in which various members having a designated shape are deposited to configure the pattern structure 700 corresponding to the designated shape in the diffraction prevention layer (DPL) (e.g., the metal layer 561 included in the opaque layer 560 of FIG. 7) has been explained. However, according to various embodiments, the pattern structure 700 may be directly configured on the surface of the diffraction prevention layer (DPL) through a patterning process with respect to the diffraction prevention layer (DPL).

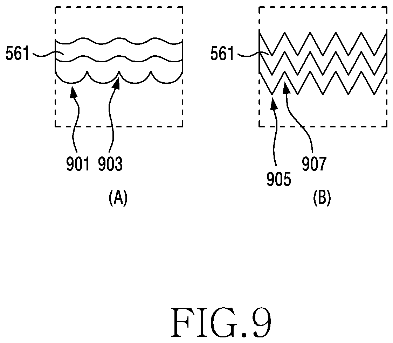

FIG. 9 is a view illustrating various pattern structures of an opaque layer included in a display of an electronic device according to an embodiment.

Referring to FIG. 7 and FIG. 9, the pattern structure 700 included in the metal layer 561 of the opaque layer 560 according to an embodiment may include a pattern in which a designated shape (e.g., a shape configured by at least one of the embossing, the uneven surface, the protrusion, and the hairline configuring the pattern structure 700) is regularly or irregularly arranged. For example, the pattern structure 700 may include a pattern A having repetitive embossing shapes which form an obtuse angle by a ridge area 901 and form an acute angle by a valley area 903 between the ridge area 901 and another ridge area adjacent thereto. For another example, the pattern structure 700 may include a pattern B having repetitive uneven or protrusion shapes which form an acute angle at both of a ridge area 905 and a valley area 907 between the ridge area 905 and another ridge area adjacent thereto. For another example, the pattern structure 700 may include a pattern in which the embossing shape and the uneven or the protrusion shape alternately repeat. Even though not illustrated, the pattern structure 700 may have patterns having various shapes capable of implementing diffuse reflection of light oriented toward the metal layer 561, as well as the patterns of the foregoing shapes.

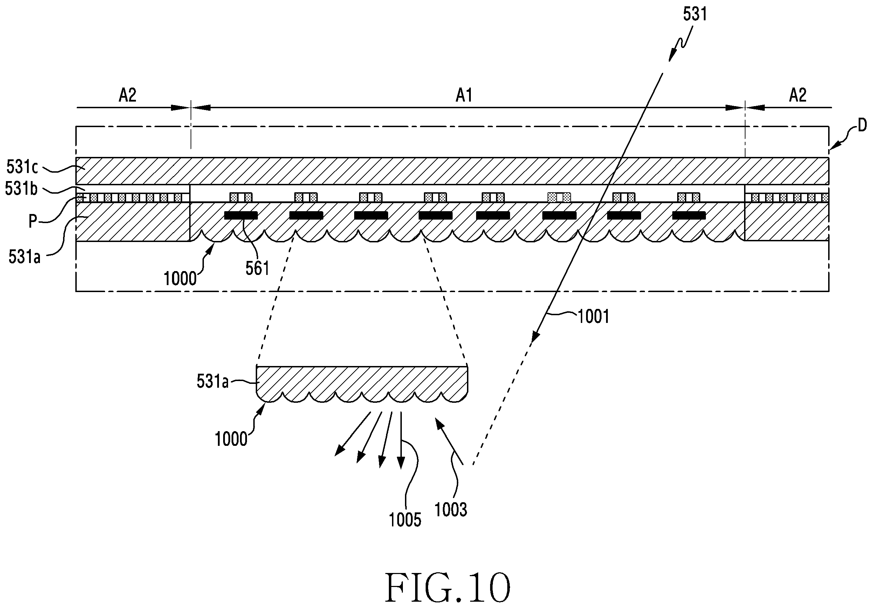

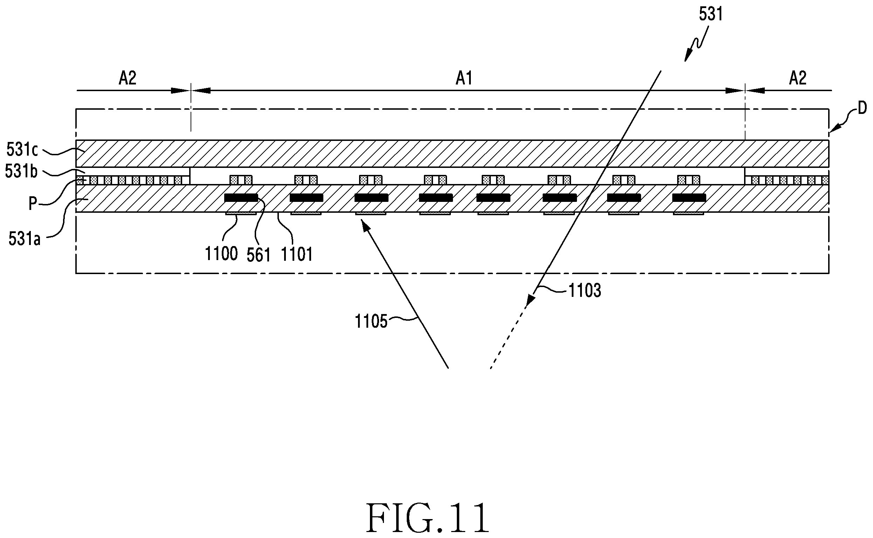

FIG. 10 is a view illustrating one example of an improvement with respect to another area of an electronic device according to an embodiment, and FIG. 11 is a view illustrating another example of an improvement with respect to another area of an electronic device according to an embodiment. For said another area of the electronic device, area C illustrated in FIG. 5 may be referred to, and area D in FIG. 10 and FIG. 11 may indicate an area implemented by at least partially improving the structure of a display corresponding to area C described above.

Referring to FIG. 10 and FIG. 11, the opaque layer (e.g., the opaque layer 560 of FIG. 7) may be omitted from the intermediate layer 531b of the display panel 531 corresponding to the transmitting area A1 (e.g., at least one first area 161 of FIG. 3) according to an embodiment, and the colored (e.g., black) metal layers 561 for minimizing diffraction of external light introduced through the transmitting area A1 may be disposed inside the substrate layer 531a included in the display panel 531. According to an embodiment, the metal layers 561 may be perpendicularly aligned and disposed to overlap at least one of a plurality of wires and a plurality of pixels (Ps) arranged to correspond to the transmitting area A1 in the substrate layer 531a.

Referring to FIG. 10, the substrate layer 531a of the display panel 531 may include a designated pattern structure 1000. In an embodiment, the pattern structure 1000 may be directly implemented on the rear surface of the substrate layer 531a, or may be implemented by depositing a member including the pattern structure 1000 on the rear surface of the substrate layer 531a. According to an embodiment, the pattern structure 1000 may be implemented on the rear surface of the substrate layer 531a corresponding to the transmitting area A1 or implemented on the rear surface of the substrate layer 531a corresponding to all of the transmitting area A1 and the surrounding active area A2. In various embodiments, the pattern structure 1000 may include at least one regular or irregular pattern from among an embossing pattern, an uneven pattern, a protrusion pattern, a hairline pattern and a pattern obtained by combining at least two of the above-mentioned patterns.

In an embodiment, the pattern structure 1000 included in the substrate layer 531a of the display panel 531 may be used for diffuse reflection of light toward the substrate layer 531a. For example, at least a part of external light 1001 introduced through the transmitting area A1 may be reflected by a component (e.g., at least one of the plurality of lenses 630 of FIG. 4) of the camera device (e.g., the camera device 600 of FIG. 4) disposed under the display panel 531, and the pattern structure 1000 may enable diffuse reflection 1005 of an reflected light 1003 toward the substrate layer 531a in unspecified multiple directions, based on a structural shape having the curve (e.g., at least one of the embossing shape, the uneven shape, the protrusion shape, and the hairline shape). Based on this, the pattern structure 1000 included in the substrate layer 531a may reduce the amount of the reflected light 1003 which passes through the substrate layer 531a to be incident to the metal layers 561, and reduce re-reflectivity of the reflected light 1003 by the metal layers 561.

Referring to FIG. 11, opaque members 1100 may be disposed on the rear surface of the substrate layer 531a of the display panel 531. For example, the opaque members 1100 may be disposed to be aligned with the metal layers 561 arranged in the substrate layer 531a to overlap at least one of a plurality of wires and a plurality of pixels (Ps) arranged to correspond to the transmitting area A1 on the rear surface of the substrate layer 531a. According to an embodiment, the opaque members 1100 may include at least one of a colored (e.g., black) polymer film and colored glass (e.g., black). In an embodiment, an opening 1101 may be provided between adjacent opaque members 1100, and the openings 1101 may be used to support an optical path of light emitted from the camera device 600 or light introduced into the camera device (e.g., the camera device 600 of FIG. 4) disposed under the display panel 531.

According to an embodiment, the opaque members 1100 arranged on the rear surface of the substrate layer 531a of the display panel 531 may be made of materials having low reflectivity, and may suppress reflection with respect to light toward the substrate layer 531a based on the low reflectivity. For example, at least a part of external light 1103 introduced through the transmitting area A1 may be reflected by a component (e.g., at least one of the plurality of lenses 630 of FIG. 4) of the camera device (e.g., the camera device 600 of FIG. 4) disposed under the display panel 531, and the opaque members 1100 may suppress secondary reflection of the reflected light 1105 toward the substrate layer 531a based on low reflectivity.

An electronic device includes a display panel and an optical sensor disposed under the display panel.

The display panel includes a first area having the first pixel density and overlapping (or, corresponding to) an angle of view of the optical sensor, a second area having the second pixel density greater than the first pixel density, and an opaque layer disposed to correspond to the first area in the display panel.

The opaque layer includes a plurality of opaque third areas including a designated pattern structure and a plurality of fourth areas including an opening between the plurality of third areas.

According to various embodiments, the first area may include a plurality of non-pixel areas and a plurality of first pixel areas based on the first pixel density.

According to various embodiments, the second area may include a plurality of second pixel areas based on the second pixel density.

According to various embodiments, the plurality of opaque third areas may be aligned to be perpendicular to a plurality of pixels included in the plurality of first pixel areas.

According to various embodiments, the designated pattern structure may include at least one of an embossing pattern, an uneven pattern, a protrusion pattern, and a hairline pattern, each of which is regularly or irregularly arranged.

According to various embodiments, the plurality of opaque third areas may include a metal layer having a designated color to prevent diffraction of external light introduced through the first area.

According to various embodiments, the designated pattern structure may be directly configured on a surface of the metal layer.

According to various embodiments, the designated pattern structure is configured by depositing a member including a pattern structure on the metal layer.

According to various embodiments, the designated pattern structure may enable diffuse reflection of at least a part of light toward the metal layer.

According to various embodiments, the designated pattern structure may include repetitive pattern shapes which form an obtuse angle by a ridge area and form an acute angle by a valley area between the ridge area and another ridge area adjacent thereto.

According to various embodiments, the designated pattern structure may include repetitive patterns shapes which form an acute angle by a ridge area and form an acute angle by a valley area between the ridge area and another ridge area adjacent thereto.

According to various embodiments, the electronic device may further include a camera device disposed under the display panel.

According to various embodiments, the optical sensor may include an image sensor included in the camera device.

An electrode device according to various embodiments described above may include a display panel including a substrate layer, an intermediate layer stacked on the substrate layer, and a protection layer stacked on the intermediate layer, and may include an optical sensor disposed under the display panel.

According to various embodiments, the display panel may include a first area having the first pixel density and overlapping (corresponding to) an angle of view of the optical sensor, and a second area having the second pixel density greater than the first pixel density.

According to various embodiments, the substrate layer of the display panel may include a designated pattern structure in a rear surface corresponding to the first area.

According to various embodiments, the first area may include a plurality of non-pixel areas and a plurality of first pixel areas based on the first pixel density.

According to various embodiments, the second area may include a plurality of second pixel areas based on the second pixel density.

According to various embodiments, the designated pattern structure may include at least one regular or irregular pattern from among an embossing pattern, an uneven pattern, a protrusion pattern, a hairline pattern.

According to various embodiments, a substrate layer of the display panel may include a metal layer having a designated color to prevent diffraction of external light which is introduced through the first area.

According to various embodiments, the designated pattern structure may be directly configured on a rear surface of the substrate layer.

According to various embodiments, the designated pattern structure is configured by depositing a member including a pattern structure on a rear surface of the substrate layer.

According to various embodiments, the designated pattern structure enables diffuse reflection of at least a part of light toward the substrate layer.

According to various embodiments, a substrate layer of the display panel may include at least one of a transparent glass substrate, a transparent quartz substrate, and a transparent resin substrate.

According to various embodiments, the electronic device may further include a camera device disposed under the display panel.

According to various embodiments, the optical sensor may include an image sensor included in the camera device.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStoreTM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device (101) comprising:
a display panel (531); and
an optical sensor disposed under the display panel,
wherein the display panel comprises:
a first area (161) having a first pixel density and corresponding to an angle of view of the optical sensor;
a second area (163) having a second pixel density greater than the first pixel density; and
an opaque layer (560) disposed to correspond to the first area in the display panel, and
wherein the opaque layer comprises a plurality of opaque third areas each comprising a metal layer (561) having a designated pattern structure and a plurality of fourth areas each comprising an opening between the plurality of third areas, wherein each opening (562) supports an optical path for external light introduced through the first area to the optical sensor; and
wherein the designated pattern structure is formed at a side of the metal layer toward to the optical sensor, and
wherein the designated pattern structure comprises a structural shape to enable diffuse reflection of reflected light from the optical sensor.

2. The electronic device of claim 1, wherein the first pixel density is based on the first area comprising a plurality (161) of non-pixel areas and a plurality of first pixel areas, and
wherein the second pixel density is based on the second area comprising a plurality of second pixel areas.

3. The electronic device of claim 2, wherein the plurality of opaque third areas are aligned to be perpendicular to a plurality of pixels included in the plurality of first pixel areas.

4. The electronic device of claim 1, wherein the designated pattern structure comprises at least one of an embossing pattern, an uneven pattern, a protrusion pattern, and a hairline pattern, each of which is a regular or irregular pattern.

5. The electronic device of claim 1, wherein a plurality of pixels is disposed on the metal layer.

6. The electronic device of claim 5, wherein the designated pattern structure is directly configured on a surface of the metal layer.

7. The electronic device of claim 5, wherein the designated pattern structure is configured by depositing a member comprising a pattern structure on the metal layer.

## Patentansprüche

1. Elektronische Vorrichtung (101), umfassend:
ein Anzeigefeld (531); und
einen optischen Sensor, der unter dem Anzeigefeld angeordnet ist,
wobei das Anzeigefeld Folgendes umfasst:
einen ersten Bereich (161), der eine erste Pixeldichte aufweist und einem Betrachtungswinkel des optischen Sensors entspricht;
einen zweiten Bereich (163), der eine zweite Pixeldichte aufweist, die größer als die erste Pixeldichte ist; und
eine opake Schicht (560), die so angeordnet ist, dass sie dem ersten Bereich in dem Anzeigefeld entspricht, und
wobei die opake Schicht eine Vielzahl von opaken dritten Bereichen, die jeweils eine Metallschicht (561) mit einer festgelegten Musterstruktur umfassen, und eine Vielzahl von vierten Bereichen, die jeweils eine Öffnung zwischen der Vielzahl von dritten Bereichen umfassen, umfasst, wobei jede Öffnung (562) einen optischen Pfad für externes Licht, das durch den ersten Bereich zu dem optischen Sensor eingeleitet wird, unterstützt; und
wobei die festgelegte Musterstruktur auf einer Seite der Metallschicht zu dem optischen Sensor hin ausgebildet ist und
wobei die festgelegte Musterstruktur eine Strukturform umfasst, um eine diffuse Reflexion von reflektiertem Licht von dem optischen Sensor zu ermöglichen.

2. Elektronische Vorrichtung nach Anspruch 1, wobei die erste Pixeldichte darauf basiert, dass der erste Bereich eine Vielzahl (161) von Nicht-Pixelbereichen und eine Vielzahl von ersten Pixelbereichen umfasst, und
wobei die zweite Pixeldichte darauf basiert, dass der zweite Bereich eine Vielzahl von zweiten Pixelbereichen umfasst.

3. Elektronische Vorrichtung nach Anspruch 2, wobei die Vielzahl von opaken dritten Bereichen so ausgerichtet ist, dass sie senkrecht zu einer Vielzahl von Pixeln ist, die in der Vielzahl von ersten Pixelbereichen enthalten ist.

4. Elektronische Vorrichtung nach Anspruch 1, wobei die festgelegte Musterstruktur mindestens eines von einem Prägemuster, einem unebenen Muster, einem Vorsprungsmuster und einem Haarlinienmuster umfasst, von denen jedes ein regelmäßiges oder unregelmäßiges Muster ist.

5. Elektronisches Vorrichtung nach Anspruch 1, wobei eine Vielzahl von Pixeln auf der Metallschicht angeordnet ist.

6. Elektronische Vorrichtung nach Anspruch 5, wobei die festgelegte Musterstruktur direkt auf einer Oberfläche der Metallschicht konfiguriert ist.

7. Elektronisches Vorrichtung nach Anspruch 5, wobei die festgelegte Musterstruktur durch Anordnen eines Elements, das eine Musterstruktur umfasst, auf der Metallschicht konfiguriert ist.

## Revendications

1. Dispositif électronique (101) comprenant :
un panneau d'affichage (531) ; et
un capteur optique disposé sous le panneau d'affichage,
dans lequel le panneau d'affichage comprend :
une première zone (161) ayant une première densité de pixels et correspondant à un angle de vue du capteur optique ;
une seconde zone (163) ayant une seconde densité de pixels supérieure à la première densité de pixels ; et
une couche opaque (560) disposée pour correspondre à la première zone du panneau d'affichage, et
dans lequel la couche opaque comprend une pluralité de troisièmes zones opaques comprenant chacune une couche métallique (561) ayant une structure de motif désignée et une pluralité de quatrièmes zones comprenant chacune une ouverture entre la pluralité de troisièmes zones, dans lequel chaque ouverture (562) supporte un chemin optique pour une lumière externe introduite à travers la première zone vers le capteur optique ; et
dans lequel la structure de motif désignée est formée sur un côté de la couche métallique en direction du capteur optique, et
dans lequel la structure de motif désignée comprend une forme structurelle pour permettre une réflexion diffuse de lumière réfléchie par le capteur optique.

2. Dispositif électronique selon la revendication 1, dans lequel la première densité de pixels est basée sur la première zone comprenant une pluralité (161) de zones de non pixels et une pluralité de premières zones de pixels, et
dans lequel la seconde densité de pixels est basée sur la seconde zone comprenant une pluralité de secondes zones de pixels.

3. Dispositif électronique selon la revendication 2, dans lequel la pluralité de troisièmes zones opaques sont alignées pour être perpendiculaires à une pluralité de pixels compris dans la pluralité de premières zones de pixels.

4. Dispositif électronique selon la revendication 1, dans lequel la structure de motif désignée comprend au moins l'un d'un motif en relief, d'un motif non uniforme, d'un motif en saillie et d'un motif à lignes fines, chacun d'eux étant un motif régulier ou irrégulier.

5. Dispositif électronique selon la revendication 1, dans lequel une pluralité de pixels sont disposés sur la couche métallique.

6. Dispositif électronique selon la revendication 5, dans lequel la structure de motif désignée est directement configurée sur une surface de la couche métallique.

7. Dispositif électronique selon la revendication 5, dans lequel la structure de motif désignée est configurée en déposant un élément comprenant une structure de motif sur la couche métallique.
